# EUROPEAN PATENT SPECIFICATION

(11) **EP 2 247 656 B1**
(45) Date of publication and mention of the grant of the patent: **10.08.2011**
(21) Application number: 09705360.7
(22) Date of filing: 30.01.2009
(51) Int. Cl.: C08K 3/34, C08K 9/04

(54) **TRANSPARENT COMPOSITE MATERIAL**
TRANSPARENTER VERBUNDWERKSTOFF
MATÉRIAU COMPOSITE TRANSPARENT

(30) Priority: 30.01.2008 JP 2008019331
(43) Date of publication of application: 10.11.2010
(73) Proprietor: Showa Denko K.K., Tokyo 105-8518 (JP)
(72) Inventor: TOITA, Ryoji, Kawasaki-shi Kanagawa 210-0858 (JP); SHIMAMURA, Kenji, Kawasaki-shi Kanagawa 210-0858 (JP)
(74) Representative: Strehl Schübel-Hopf & Partner
(86) International application number: PCT/JP2009/052012
(87) International publication number: WO 2009/096607

(56) References cited:
- WO-A-99/54393
- WO-A-2008/010610
- JP-A- 2005 113 107

## Description

### TECHNICAL FIELD

The present invention relates to a transparent composite material having a small coefficient of thermal expansion, a method for producing the same, a display device and a substrate for a solar cell using the same.

### BACKGROUND ART

Glass has been widely used as a substrate for a display device such as a liquid crystal display device and an organic EL display device, a substrate for a color filter, a substrate for a solar cell, and the like. In recent years, however, a plastic material is being considered as a substitute for a glass substrate owing to such reasons that the glass substrate is liable to fracture, cannot be bent, is not suitable for reduction in weight due to the large specific gravity thereof, and the like. For example, substrates made of polyethylene terephthalate, polyethylene naphthalate, polycarbonate, polyolefin or polyethersulfone are proposed (for example, in JP-A-2007-268711, Patent Document 1).

However, the conventional plastic material for substituting for glass has a larger coefficient of thermal expansion than glass. Accordingly, upon producing a display substrate with the material, the difference in coefficient of thermal expansion between the plastic substrate and a transparent electrode formed thereon produces such problems as a warpage, breakage of wiring, and the like upon heating or cooling, and therefore, a transparent plastic substrate having a small coefficient of thermal expansion is being demanded.

JP-T-2002-512286 (the term "JP-T" as used herein means a published Japanese translation of a PCT patent application) (Patent Document 2, WO99/054393) discloses an epoxy vinyl ester resin or an unsaturated polyester resin containing a lamellar clay mineral, but the invention intends to improve heat resistance and mechanical strength. In the case where the multilayered inorganic material (inorganic layered silicate) is added in a low concentration (from 2 to 6%) as disclosed in the example of Patent Document 2, the transparency of the resin itself can be maintained, but the intended low coefficient of thermal expansion cannot be attained. Accordingly, the document does not relate to a composition that has transparency and a low expansion coefficient.
[Patent Document 1] JP-A-2007-268711
[Patent Document 2] JP-T-2002-512286

### PROBLEMS TO BE SOLVED BY THE INVENTION

An object of the invention is to provide a transparent composite material that has a small coefficient of thermal expansion, is excellent in transparency, and can be suitably used as a plastic substrate for a display such as a liquid crystal display device and an organic EL display device, a substrate for a display, such as a substrate for electronic paper and the like, and a substrate for a solar cell.

### MEANS FOR SOLVING THE PROBLEMS

As a result of earnest investigations made by the inventors for solving the problems, it has been found that the problems can be solved by a transparent composite material constituted by a vinyl ester resin composition having dispersed therein synthetic smectite having been cationically exchanged with a quaternary ammonium salt and/or a quaternary phosphonium salt. Accordingly, the invention relates to a transparent composite material, a method for producing the same, and a display device and a substrate for a solar cell using the transparent composite material as a substrate, which are described below.
1. A transparent composite material comprising a cured product of a resin composition having from 60 to 90% by mass of a vinyl ester resin composition which has a vinyl ester resin being synthesized from an aliphatic epoxy compound and from 10 to 40% by mass of synthetic smectite that is organized with a quaternary ammonium salt and/or a quaternary phosphonium salt and has a number average particle diameter of from 10 to 300 nm and an aspect ratio of from 10 to 300, the composition being cured.
2. The transparent composite material according to 1 above, wherein the vinyl ester resin is synthesized from an epoxy compound having an alicyclic structure.
3. The transparent composite material according to 1 or 2 above, wherein the vinyl ester resin is synthesized from a hydrogenated bisphenol A epoxy resin.
4. The transparent composite material according to one of 1 to 3 above, wherein the vinyl ester resin composition comprises from 30 to 100% by mass of a vinyl ester resin and from 0 to 70% by mass of a reactive monomer having an ethylenic unsaturated group.
5. The transparent composite material according to 1 above, wherein the synthetic smectite is at least one selected from synthetic hectorite, synthetic saponite and synthetic stevensite.
6. The transparent composite material according to 1 above, wherein the quaternary ammonium salt for organizing the synthetic smectite is at least one selected from lauryltrimethylammonium salt, stearyltrimethylammonium salt, trioctylmethylammonium salt, distearyldimethylammonium salt, di-hydrogenated beef tallow dimethylammonium salt, distearyldibenzylammonium salt and N-polyoxyethylene-N-lauryl-N,N-dimethylammonium salt.
7. The transparent composite material according to 1, 5 or 6 above, wherein a hydroxyl group present on a surface of the synthetic smectite is treated with a surface modification agent.
8. The transparent composite material according to 7 above, wherein the surface modification agent is selected from a silane coupling agent, a titanate coupling agent, a glycidyl compound, an isocyanate compound, carboxylic acids and alcohols.
9. A transparent plate comprising the transparent composite material according to one of 1 to 8 above and having an average coefficient of thermal expansion of 30 ppm/°C or less in a planar direction at from 50 to 250°C and a total light transmittance of 85% or more per 100 µm in thickness.
10. A method for producing the transparent composite material according to one of 1 to 8 above, comprising the steps of: coating a composition comprising a vinyl ester resin compound, synthetic smectite and a solvent, before curing, on a flat plane having a smooth surface; then drying the solvent; holding the flat plane with sheets or films having a smooth surface; and curing with an electron beam (EB), an ultraviolet ray (UV) or heat.
11. A display device comprising, as a substrate, the transparent composite material according to one of 1 to 8 above.
12. The display device according to 11 above, wherein the display device is a liquid crystal display, an organic EL display or electronic paper.
13. A substrate for a solar cell comprising, as a substrate, the transparent composite material according to one of 1 to 8 above.

### EFFECTS OF THE INVENTION

The conventional plastic substrate for a display suffers such problems as a warpage, breakage of wiring, and the like upon heating or cooling due to the large difference in coefficient of thermal expansion between the substrate and the transparent electrode provided thereon. The substrate for a display using the transparent composite material of the invention solves the problems owing to the considerably small coefficient of thermal expansion and can provide a display having high durability, which is considerably useful industrially. The transparent composite material of the invention can provide a transparent sheet having flexibility and a small coefficient of thermal expansion by employing a specific resin composition, and thus can be used as a flexible display substrate for a liquid crystal display, an organic EL display, electronic paper and the like; a substrate for a solar cell; and the like.

### BEST MODE FOR CARRYING OUT THE INVENTION

### (Transparent Composite Material)

A glass cloth, nanosilica and the like have been known as a filler that is capable of improving mechanical characteristics and thermal characteristics of a resin while maintaining transparency thereof. However, a glass cloth has a coefficient of thermal expansion that is largely different from a resin, and thus the resin is whitened due to microcracks upon heating and cooling to lose transparency of the material. In the case where nanosilica is filled, the transparency can be maintained when the addition amount thereof is small, but it is necessary to fill nanosilica in a large amount for attaining such a low coefficient of thermal expansion that is required for use as a display substrate and a substrate for a solar cell, and the transparency cannot be maintained in this case. In the case where natural clay, such as bentonite and the like, is filled, mechanical characteristics and thermal characteristics can be improved, but impurities, such as iron oxide, quartz and the like, in the natural clay crystals cannot be completely removed, thereby failing to improve all mechanical characteristics, thermal characteristics and transparency. The transparent composite material of the invention comprises a vinyl ester resin composition which contains a vinyl ester resin synthesized from an aliphatic epoxy compound having dispersed therein synthetic smectite having specific properties, and the transparent composite material has an average coefficient of thermal expansion in the planar direction of 30 ppm/°C or less at from 50 to 250°C.

In the invention, the transparency of the transparent composite material is evaluated in terms of total light transmittance. The transparent composite material of the invention has a total light transmittance of 85% or more per 100 µm in thickness, and a haze value of 5% or less. The total light transmittance is more preferably 90% or more. The transparent composite material preferably has a haze value of 5% or less, more preferably, 3% or less. In the case where the haze value exceeds 5%, transmitted light is distorted to lose sharpness. The total light transmittance is measured according to JIS K7361-1, and the haze value is measured according to JIS K7136.

The transparent composite material of the invention is not limited in shape, and a molded article thereof in a shape of a film, a sheet, a flat plate or the like is particularly preferred. An article having a thickness of from 10 to 200 µm is referred to as a film, an article having a thickness of larger than 200 µm and 5,000 µm or less is referred to as a sheet, and an article having a thickness larger than 5,000 µm is referred to as a plate, but hereinafter, the articles are referred to as sheets irrespective of the thickness of a film, a sheet or a plate.

### (Vinyl Ester Resin Composition)

The vinyl ester resin in the invention is also referred to as epoxy (meth)acrylate, and generally means (1) a resin having an ethylenic unsaturated group, synthesized by ring-opening reaction of an epoxy compound, represented by an epoxy resin, and a carboxyl group of a carboxyl compound having a radical polymerizable carbon-carbon double bond (ethylenic unsaturated group) such as (meth)acrylic acid, or (2) a resin having a polymerizable unsaturated group, synthesized by ring-opening reaction of a compound having a carboxyl group and an epoxy group of a polymerizable unsaturated compound having an epoxy group in the molecule thereof, such as glycidyl (meth)acrylate. Details thereof are disclosed in "Polyester Jushi Handbook" (Polyester Resin Handbook), published by Nikkan Kogyo Shimbun, Ltd., 1988, pp. 336-357, and the like. The vinyl ester resin can be produced by a known method. In the invention, the vinyl ester resin composition means a composition containing the vinyl ester resin and a reactive monomer.

As the vinyl ester resin capable of exhibiting a transparency and a low coefficient of thermal expansion as a transparent sheet, a vinyl ester resin synthesized from an aliphatic epoxy compound is essential, and in particular, a vinyl ester resin synthesized from an epoxy compound having an alicyclic structure is preferred. For attaining a low coefficient of thermal expansion (30 ppm/°C or less) by adding synthetic smectite while maintaining the transparency, it is necessary to add a large amount (40% by mass or more) of synthetic smectite to a thermosetting resin. In the transparent composite material, however, the transparency and the low coefficient of thermal expansion can be attained, but the mechanical strength inherent to the resin cannot be exhibited due to the large addition amount of synthetic smectite, thereby providing a brittle and fragile material. On the other hand, in the case where the vinyl ester resin synthesized from an aliphatic epoxy compound, particularly an epoxy compound having an alicyclic structure, is used, the transparency and the heat resistance are well balanced, and a low coefficient of thermal expansion can be attained even though the addition amount of the synthetic smectite is reduced to a value lower than 40% by mass.

Examples of the alicyclic epoxy compound include a hydrogenated bisphenol A epoxy resin, a cyclohexane type compound such as diglycidyl 1,2-cyclohexanedicarboxylate, 3,4-epoxycyclohexenylmethyl-3',4'-epoxycyclohexene carboxylate and bis(3,4-epoxy-6-methylcyclohexylmethyl) adipate; a norbornene type compound such as 3-oxatricyclo[3.2.1.02,4]octane-6-carboxylic acid and 3-oxatricyclo[3.2.1.02,4]oct-6-yl methyl ester; an adamantane type compound such as 7-oxabicyclo[4.1.0]heptane-3-carboxylic acid and tricyclo[3.3.1.13,7]decan-1,3-diyl ester. Among these, a hydrogenated bisphenol A epoxy resin is more preferred from the standpoint of transparency, ductility and heat resistance. A resin having a molecular weight of 800 or more can further improve the ductility. Even in the case where an epoxy resin as a raw material has an average molecular weight of less than 500, the molecular weight may be increased by using partly such dicarboxylic acids such as succinic acid, adipic acid, dodecanedicarboxylic acid and 1,4-cyclohexanedicarboxylic acid.

Upon producing the vinyl ester resin, the reaction is performed by charging the above-mentioned epoxy compound and the ethylenic unsaturated compound having a carboxyl group in a reactor, into which air is blown. The reaction temperature is preferably from 70 to 150°C, and more preferably from 80 to 140°C. In the case where the reaction temperature is less than 70°C, it is not economical since the reaction time is prolonged. In the case where the reaction temperature exceeds 150°C, the system is gelled in many cases.

A reaction catalyst may not be added, but it is economical when the catalyst is added since the reaction time is shortened. Preferred examples of the catalyst include a tertiary amine compound, a phosphine compound and an onium salt. Specific examples of the tertiary amine compound include dimethylcyclohexylamine, N,N-dimethylpiperazine and benzyldimethylamine; and examples of the phosphine compound include triphenylphosphine, tritolylphosphine and tricyclohexylphosphine. Examples of the onium salt include a quaternary ammonium salt and a quaternary phosphonium salt; examples of the quaternary ammonium salt include tetramethylammonium chloride, tetrabutylammonium chloride, tetramethylammonium bromide, tetrabutylammonium bromide and decyltrimethylammonium chloride; and examples of the quaternary phosphonium salt include tetraphenylphosphonium chloride, benzyltriphenylphosphonium chloride, tetraphenylphosphonium bromide and tetramethylphosphonium tetraphenylborate. The addition amount of the catalyst is preferably from 0.05 to 3 parts by mass, and more preferably from 0.1 to 2 parts by mass, per 100 parts by mass in total of the epoxy resin and the ethylenic unsaturated compound having a carboxyl group. An amount of the catalyst less than 0.05 part by mass is not preferred since no effect of accelerating the reaction is exhibited, and an amount of the catalyst exceeding 3 parts by mass is not preferred since the resin is significantly colored.

### (Reactive Monomer)

In the vinyl ester resin composition of the invention, a reactive monomer may be added for such purposes as control of the curing rate, adjustment of the viscosity (improvement of workability), enhancement of the crosslinking density and addition of functionalities. The reactive monomer is not particularly limited, and various kinds thereof may be used, and a monomer having a radical polymerizable carbon-carbon double bond (ethylenic unsaturated group) such as a vinyl group and an allyl group is preferred for reacting with the vinyl ester resin composition. Examples of the monomer include a monofunctional monomer having one ethylenic unsaturated group in one molecule and a polyfunctional monomer having two or more ethylenic unsaturated groups in one molecule. Preferred specific examples of the reactive monomer are described below.

Examples of the monofunctional monomer include an aliphatic (meth)acrylate, such as methyl (meth)acrylate, ethyl (meth) acrylate, n-butyl (meth)acrylate, sec-butyl (meth)acrylate, t-butyl (meth)acrylate, 2-ethylhexyl (meth)acrylate, octyl (meth)acrylate, dodecyl (meth)acrylate, octadecyl (meth)acrylate, isobornyl(meth)acrylate, cyclohexyl (meth)acrylate, methylcyclohexyl meth)acrylate, 4-t-butylcyclohexyl (meth)acrylate, dicyclopentenyloxymethyl (meth)acrylate, dicyclopentenyloxyethyl (meth)acrylate, ethoxyethyl (meth)acrylate, ethoxydiethylene glycol (meth)acrylate, 2-hydroxyethyl (meth)acrylate and 2-hydroxypropyl (meth)acrylate; an aromatic (meth)acrylate, such as benzyl (meth)acrylate, phenyl (meth)acrylate, phenoxyethyl (meth)acrylate, phenoxydiethylene glycol (meth)acrylate, 1-naphthyl (meth)acrylate, fluorophenyl (meth)acrylate, chlorophenyl (meth)acrylate, cyanophenyl (meth)acrylate, methoxyphenyl (meth)acrylate and biphenyl (meth)acrylate; a haloalkyl (meth)acrylate such as fluoromethyl (meth)acrylate and chloromethyl (meth)acrylate; a (meth)acrylate compound such as glycidyl (meth)acrylate, alklylamino (meth)acrylate and cyanoacrylate ester; a nitrogen-containing monomer such as acrylamide, N,N-dimethylacrylamide, N,N-diehylacrylamide, N-vinylformamide, N-vinylacetamide, N-vinyl-ε-caprolactam, N-vinylpyrrolidone, 1-vinylimidazole, N-vinylcarbazole, N-vinylmorpholine, N-vinylpyridine and acryloylmorpholine; styrene, α-methylstyrene, chlorostyrene, styrenesulfonic acid, 4-hydroxystyrene, vinyltoluene, vinyl acetate, vinyl propionate, vinyl benzoate and the like.

Examples of the polyfunctional monomer include a di(meth)acrylate compound such as ethylene glycol di(meth)acrylate, diethylene glycol di(meth)acrylate, triethylene glycol di(meth)acrylate, tetraethylene glycol di(meth)acrylate, polyethylene glycol di(meth)acrylate, propylene glycol di(meth)acrylate, dipropylene glycol di(meth)acrylate, tripropylene glycol di(meth)acrylate, 1,3-butylene glycol di(meth)acrylate, 1,4-butanediol di(meth)acrylate, 1,5-pentanediol di(meth)acrylate, 1,6-hexanediol di(meth)acrylate, neopentyl glycol di(meth)acrylate, 1,9-nonanediol di(meth)acrylate, 1,10-decanediol di(meth)acrylate, dimethyloltricyclodecane di(meth)acrylate, polybutadiene di(meth)acrylate, 2,2-bis(4-(meth)acryloyloxyphenyl)propane, 2,2-bis(4-(ω-(meth)acryloyloxypolyethoxy)phenyl)propane, and di(meth)acrylate of an ethylene oxide adduct of bisphenol A; a trifunctional crosslinking monomer such as trimethylolethane tri(meth)acrylate, trimethylolpropane tri(meth)acrylate, triacrylate of an ethylene oxide adduct of trimethylolpropane and pentaerythritol tri(meth)acrylate; a tetrafunctional or higher polyfunctional acrylate such as pentaerythritol tetra(meth)acrylate, tetra(meth)acrylate of an ethylene oxide adduct of pentaerythritol, dipentaerythritol hexa(meth)acrylate and dipentaerythritol hexa(meth)acrylate; an aromatic diallyl carboxylate compound such as diallyl phthalate, diallyl isophthalate, dimethallyl isophthalate, diallyl terephthalate, triallyl trimellitate, diallyl 2,6-naphthalenedicarboxylate, diallyl 1,5-naphthalanedicarboxylate, allyl 1,4-xylenedicarboxylate and diallyl 4,4'-diphenyldicarboxylate; and an allyl compound such as diallyl cyclohexanedicarboxylate, tri(meth)allyl isocyanurate, tri(meth)allyl cyanurate and diallyl chlorendate.

The reactive monomers may be used solely or in combination of two or more of them. The amount of the reactive monomer used is not particularly limited, and from 0 to 70% by mass of the reactive monomer is preferably used with from 30 to 100% by mass of the vinyl ester resin. An amount of the reactive monomer used exceeding 70% by mass is not preferred since the excellent transparency of the vinyl ester resin may not be exhibited, and the mechanical strength inherent to the vinyl ester resin may be decreased.

### (Synthetic Smectite)

The synthetic smectite used in the invention is not particularly limited as far as it has a number average particle diameter of from 10 to 300 nm and an aspect ratio of from 10 to 300.

In the case where the transparent composite sheet of the invention is used as a substrate for a display, it is necessary that the average particle diameter is sufficiently smaller than the wavelength of visible light. The visible light referred herein means light having a wavelength in a range of from 400 to 800 nm. Accordingly, the number average particle diameter of the synthetic smectite is preferably in a range of from 10 to 300 nm, and more preferably in a range of from 30 to 200 nm. In the case where the number average particle diameter is less than 10 nm, there is a tendency that the coefficient of thermal expansion in the plane direction of the transparent sheet is not sufficiently small, and in the case where it exceeds 300 nm, particles having a particle diameter overlapping the visible light wavelength are contained, and thus it is not preferred from the standpoint of transparency. The number average particle diameter of the synthetic smectite referred herein means a number average particle diameter obtained by measuring the particles dispersed in a solvent by a dynamic light scattering method. The number average particle diameter by a dynamic light scattering method can be obtained, for example, by referring to "Ryushi-kei Keisoku Gijutsu" (Particle Diameter Measuring Techniques), edited by The Society of Powder Technology, Japan, 1994, pp. 169-179. Specific examples of the measuring equipment include a dynamic light scattering particle diameter distribution measuring equipment (for example, Model LB-550, produced by Horiba, Ltd.). It can be considered that the number average particle diameter of the synthetic smectite obtained by the dynamic light scattering method is substantially the same as the number average particle diameter of the synthetic smectite after dispersing in the resin in the invention.

The aspect ratio (Z) of the synthetic smectite is expressed by the relationship, Z = L/a. L represents the number average particle diameter in a solvent, which L is obtained by the dynamic light scattering method, and a represents the unit thickness of the synthetic smectite. The unit thickness a can be calculated by measuring diffraction peaks of a planar inorganic substance by a powder X-ray diffractometry. The synthetic smectite of the invention has an aspect ratio in a range of from 10 to 300, and more preferably in a range of from 30 to 100. The aspect ratio is preferably 10 or more from the standpoint that it is liable to be oriented in the plane direction of the transparent sheet. In the case where the synthetic smectite has an aspect ratio of less than 10, the coefficient of thermal expansion may not be in a prescribed range (preferably 30 ppm/°C or less). In the case where synthetic smectite having an aspect ratio exceeding 300 is used, the total light transmittance of the transparent sheet may be decreased.

The synthetic smectite may be synthesized by a known method (for example, Haruo Shirozu, "Nendokobutsu-gaku, Nendo Kagaku no Kiso" (Clay Mineralogy, Basis of Clay Science), published by Asakura Publishing Co., Ltd., 1988, pp. 98-100), and commercially available synthetic smectite may be used. Examples of the synthetic smectite that are preferably used include synthetic hectorite, synthetic saponite and synthetic stevensite, and examples of the commercially available product include Synthetic Smectite SWN (synthetic hectorite), produced by Co-op Chemical Co., Ltd., Synthetic Inorganic Polymer Smecton SA (synthetic saponite), produced by Kunimine Industries Co., Ltd., Synthetic Silicate Laponite (synthetic hectorite), produced by Rockwood Specialties, Inc., and Synthetic Silicate Magnedium Salt Ionite (synthetic stevensite), produced by Mizusawa Industrial Chemicals, Ltd. More preferred examples among these include Synthetic Smectite SWN, produced by Co-op Chemical Co., Ltd. from the standpoint of transparency, cation exchange capacity and size.

The synthetic smectite is made to be hydrophobic (organizing treatment) with a quaternary ammonium salt and/or a quaternary phosphonium salt for dispersing in the resin uniformly. Examples of the method for organizing treatment include a method of exchanging exchangeable metallic cations such as sodium and calcium present among the flake-like crystalline layers of the synthetic smectite with various kinds of substances having cationic property such as a cationic surfactant, to insert the substances among the crystalline layers of the synthetic smectite (intercalation). The organizing method is also referred to as a cation exchanging method with a cationic surfactant, and is effective for the case where the resin component of the transparent composite material of the invention has low polarity, whereby the affinity between the synthetic smectite and the low polar resin can be improved, and the synthetic smectite can be finely dispersed in the low polar resin more uniformly.

The cation exchange capacity of the synthetic smectite in this case is not particularly limited, and is preferably from 50 to 1,200 milli-equivalent per 100 g. In the case where the cation exchange capacity is less than 50 milli-equivalent per 100 g, the amount of the cationic substance intercalated among the crystalline layers of the synthetic smectite is small, and there are cases where the crystalline layers are not sufficiently made to be non-polar (hydrophobic). In the case where the cation exchange capacity exceeds 1,200 milli-equivalent per 100 g, the bonding strength among the crystalline layers of the synthetic smectite becomes too large, whereby the crystalline flakes may be difficult to be released.

The cationic surfactant used herein is not particularly limited, and examples thereof include a quaternary ammonium salt and a quaternary phosphonium salt. Among these, an alkylammonium ion salt having 6 or more carbon atoms, an aromatic quaternary ammonium ion salt and a heterocyclic quaternary ammonium ion salt are preferably used since the crystalline layers of the synthetic smectite can be sufficiently made to be hydrophobic.

The quaternary ammonium salt is not particularly limited, and examples thereof include a trimethylalkylammonium salt, a triethylalkylammonium salt, a tributylalkylammonium salt, a dimethydialkylammonium salt, a dibutyldialkylammonium salt, a methylbenzyldialkylammonium salt, a dibenzyldialkylammonium salt, a trialkylmethylammonium salt, a trialkylethylammonium salt, a trialkylbutylammonium salt; a quaternary ammonium salt having an aromatic ring, such as benzylmethyl{2-[2-(p-1,1,3,3-tetramethylbutylphenoxy)ethoxy]ethyl}ammonium chloride and the like; a quaternary ammonium salt derived from an aromatic amine, such as trimethylphenylammonium and the like; a quaternary ammonium salt having a heterocyclic ring, such as an alkylpyridinium salt, imidazolium salt and the like; a dialkyl quaternary ammonium salt having two polyethylene glycol chains, a dialkyl quaternary ammonium salt having two polypropylene glycol chains, a trialkyl quaternary ammonium salt having one polyethylene glycol chain, a trialkyl quaternary ammonium salt having one polypropylene glycol chain and the like. Among these, lauryltrimethylammonium salt, stearyltrimethylammonium salt, trioctylmethylammonium salt, distearyldimethylammonium salt, di-hydrogenated beef tallow dimethylammonium salt, distearyldibenzylammonium salt, N-polyoxyethylene-N-lauryl-N,N-dimethylammonium salt and the like are preferred. These quaternary ammonium salts may be used solely or in combination of two or more of them.

The quaternary phosphonium salt is not particularly limited, and examples thereof include dodecyltriphenylphosphonium salt, methyltriphenylphosphonium salt, lauryltrimethylphosphonium salt, stearyltrimethylphosphonium salt, trioctylmethylphosphonium salt, distearyldimethylphosphonium salt and distearyldibenzylphosphonium salt. These quaternary phosphonium salts may be used solely or in combination of two or more of them.

Upon enhancing the dispersibility of the synthetic smectite by using the quaternary ammonium salt and/or quaternary phosphonium salt with the aliphatic vinyl ester resin, aliphatic quaternary ammonium salt and/or quaternary phosphonium salt are preferably used, and a trialkylmethylammonium salt and a trialkyl quaternary ammonium salt having one polypropylene glycol chain are particularly preferred.

Furthermore, a surface modification agent may be used for dispersing the synthetic smectite highly in the vinyl ester resin. As for the kind of the surface modification agent capable of enhancing the dispersibility, in general, an aliphatic surface modification agent is preferably used for a vinyl ester resin containing a large amount of aliphatic carbon chains.

The synthetic smectite used in the invention may be subjected to the organizing treatment not only among the layers but also on the surface thereof. The surface of the synthetic smectite has a functional group such as a hydroxyl group, and therefore, can be organized with a compound having a functional group having reactivity with the hydroxyl group. The compound having a functional group capable of being chemically bonded to the hydroxyl group

(surface modification agent) is not particularly limited, and examples thereof include compounds having the functional group such as a silane compound (silane coupling agent), a titanate compound (titanate coupling agent), a glycidyl compound, an isocyanate compound, carboxylic acids and alcohols. These compounds may be used solely or in combination of two or more of them.

Among the compounds, a silane compound is preferably used. Specific examples of the silane compound include vinyltrimethoxysilane, vinyltriethoxysilane, γ-aminopropyltrimethoxysilane, γ-aminopropylmethyldimethoxysilane, γ-aminopropyldimethylmethoxysilane, γ-aminopropyltriethoxysilane, γ-aminopropylmethyldiethoxysilane, γ-aminopropyldimethylethoxysilane, methyltriethoxysilane, dimethyldimethoxysilane, trimethylmethoxysilane, hexyltrimethoxysilane, hexyltriethoxysilane, octadecyltrimethoxysilane, octadecyltriethoxysilane, γ-methacryloxypropylmethyldimethoxysilane, γ-methacryloxypropylmethyldiethoxysilane, γ-methacryloxypropyltrimethoxysilane and γ-methacryloxypropyltriethoxysilane. These silane compounds may be used solely or in combination of two or more of them.

The content of the synthetic smectite in the transparent composite material is preferably in a range of from 10 to 40% by mass, and more preferably in a range of from 15 to 30% by mass, based on the total amount of the vinyl ester resin composition which comprises a vinyl ester resin synthesized from an aliphatic epoxy compound and the synthetic smectite. In the case where the content of the synthetic smectite is less than 10% by mass, the average coefficient of thermal expansion of the transparent composite material at from 50 to 250°C becomes larger than 30 ppm/°C. In the case where the content of the synthetic smectite exceeds 40% by mass, it become difficult to disperse the synthetic smectite uniformly in the resin, and the mechanical strength of the transparent composite material is decreased to be brittle and fragile.

### (Curing Agent)

Upon curing the vinyl ester resin composition of the invention, electron beam (EB) curing is preferably employed, and ultraviolet ray (UV) curing and thermal curing may also be employed. In the case where UV or thermal curing is employed, a curing agent may be used. The curing agent that can be used is not particularly limited, and those that are ordinarily used as a curing agent for a polymerizable resin may be used. Among these, a radical polymerization initiator is preferably added from the standpoint of polymerization initiation of a (meth)acryloyloxy group. Examples of the radical polymerization initiator include a photopolymerization initiator, an organic peroxide and an azo compound. For UV-curing the vinyl ester resin composition of the invention, a photopolymerization initiator is particularly preferred.

Examples of the photopolymerization initiator include 2,2-dimethoxy-1,2-diphenylethan-1-one, 1-hydroxycyclohexyl phenyl ketone, benzophenone, 2-methyl-1-(4-methylthiophenyl)-2-morpholinopropan-1-one, 2-benzyl-2-dimethylamino-1-(4-morpholinophenyl)butanone-1, 2-hydoxy-2-methyl-1-phenylpropan-1-one, 1-[4-(2-hydroxyethoxy)phenyl]-2-hydroxy-2-one, 2-hydroxy-1-{4-[4-(2-hydroxy-2-methylpropyonyl)benzyl]-phenyl}-2-methylpropan-1-one, oxyphenylacetic acid 2-[2-oxo-2-phenylacetoxyethoxy]ethyl ester, oxyphenylacetic acid 2-[2-hydroxyethoxy]ethyl ester, phenylglyoxylic acid methyl ester, 2-dimethylamino-2-(4-methylbenzyl)-1-(4-morpholin-4-ylphenyl)butan-1-one, bis(2,4,6-trimethylbenzoyl)phenylphosphine oxide, 1,2-octadione, 1-[4-(phenylthio)phenyl-2-(O-benzoyloxime)], ethanone, 1-[9-ethyl-6-(2-methylbenzoyl)-9H-carbazol-3-yl]-1-(O-acetyloxime), iodonium (4-methylphenyl)[4-(2-methylpropyl)phenyl] hexafluorophosphate(1-), ethyl-4-dimethylaminobenzoate, 2-ethylhexyl-4-dimethylaminobenzoate and 2,4,6-trimethylbenzoyldiphenylphosphine oxide.

As the organic peroxide, known ones may be used, such as a dialkyl peroxide, an acyl peroxide, a hydroperoxide, a ketone peroxide and a peroxyester. Specific examples thereof include diisobutyryl peroxide, cumyl peroxyneodecanoate, di-n-propyl peroxydicarbonate, diisopropyl peroxydicarbonate, di-sec-butyl peroxydicarbonate, 1,1,3,3-tetramethylbutyl peroxyneodecanoate, di(4-t-butylcyclohexyl) peroxydicarbonate, di(2-ethylhexyl) peroxidicarbonate, t-hexyl peroxyneodecanoate, t-butyl peroxyneodecanoate, t-butyl peroxyneoheptanoate, t-hexyl peroxypivalate, t-butyl peroxypivalate, di(3,5,5-trimethylhexanoyl) peroxide, dilauroyl peroxide, 1,1,3,3-tetramethylbutyl peroxy-2-ethylhexanoate, disuccinic acid peroxide, 2,5-dimethyl-2,5-di(2-ethylhexanoylperoxy)hexane, t-hexyl peroxy-2-ethylhexanoate, di(4-methylbenzoyl) peroxide, t-butyl peroxy-2-ethylhexanoate, di(3-methylbenzoyl) peroxide, benzoyl(3-methylbenzoyl) peroxide, dibenzoyl peroxide, 1,1-di(t-butylperoxy)-2-methylcyclohexane, 1,1-di(t-hexylperoxy)-3,3,5-trimethylcyclohexane, 1,1-di(t-butylperoxy)cyclohexane, 2,2-bis[4,4-di(t-butylperoxy)cyclohexyl]propane, t-hexylperoxyisopropyl monocarbonate, t-butylperoxymaleic acid, t-butyl peroxy-3,5,5-trimethylhexanoate, t-butyl peroxylaurate, t-butylperoxyisopropyl monocarbonate, t-butylperoxy-2-ethylhexyl monocarbonate, t-hexyl peroxybenzoate, 2,5-dimethyl-2,5-di(benzoylperoxy)hexane, t-butyl peroxyacetate, 2,2-di(t-butylperoxy)butane, t-butyl peroxybenzoate, n-butyl-4,4-di(t-butylperoxy) valerate, di(t-butylperoxyisopropyl)benzene, dicumyl peroxide, di(t-hexyl) peroxide, 2,5-dimethyl-2,5-di(t-butylperoxy)hexane, t-butylcumyl peroxide, di-t-butyl peroxide, p-menthane hydroperoxide, 2,5-dimethyl-2,5-di(t-butylperoxy)hexyne-3, diisopropylbenzene hydroperoxide, 1,1,3,3-tetramethylbutyl hydroperoxide, cumene hydroperoxide and t-butyl hydroperoxide.

Examples of the azo compound include 2,2'-azobis(4-methoxy-2,4-dimethylvaleronitrile, 2,2'-azobis(2,4-dimethylvaleronitrile), dimethyl 2,2'-azobis(2-methylpropionate), 2,2'-azobis(2-methylbutyronitrile), 1,1'-azobis(cyclohexane-1-carbonitrile), 2,2'-azobis[N-(2-propenyl)-2-methylpropionamide], 1-[(1-cyano-1-methylethyl)azo]formamide, 2,2'-azobis(N-butyl-2-methylpropionamide) and 2,2'-azobis(N-cyclohexyl-2-methylpropionamide).

The radical polymerization initiators may be used solely or in combination of two or more of them. The amount of the curing agent mixed is not particularly limited, and is preferably from 0.1 to 10 parts by mass, and more preferably from 0.5 to 5 parts by mass, per 100 parts by mass of the vinyl ester resin composition. In the case where the amount of the curing agent mixed is less than 0.1 part by mass, a sufficient curing rate may not be obtained, and in the case where the amount exceeds 10 parts by mass, there are cases where the final cured product become brittle to decrease the mechanical strength thereof.

### (Additive)

To the vinyl ester resin composition for a transparent electroconductive substrate of the invention, additives may be added depending on necessity, such as an ultraviolet ray absorbent, an antioxidant, a defoaming agent, a leveling agent, a releasing agent, a lubricant, a water repellent, a flame retarder, a contraction preventing agent and a crosslinking assistant, for improving hardness, strength, moldability, durability and water resistance.

The antioxidant is not particularly limited, and products that are ordinarily used may be used. Among these, a phenol antioxidant, an amine antioxidant, a sulfur antioxidant, a phosphorus antioxidant and the like are preferred, and a phenol antioxidant is particularly preferred. Examples of the phenol antioxidant include 2,6-di-t-butyl-p-cresol, 4,4-butylidenebis(6-t-butyl-3-methylphenol), 2,2'-methylenebis(4-methyl-6-t-butylphenol), 2,2'-methylenebis(4-ethyl-6-t-butylphenol), 2,6-di-t-butyl-4-ethylphenol, 1,1,3-tris(2-methyl-4-hydroxy-5-t-butylphenyl)butane, n-octadecyl-3-(3,5-di-t-butyl-4-hydroxyphenyl) propionate, tetrakis(methylene-3-(3,5-di-t-butyl-4-hydroxyphenyl) propionate)methane, triethylene glycol bis[3-(3-t-butyl-4-hydroxy-5-methylphenyl) propionate], tris(3,5-di-t-butyl-4-hydroxybenzyl) isocyanurate, 4,4-thiobis(6-t-butyl-3-methylphenol), 3,9-bis[2-[3-(3-t-butyl-4-hydroxy-5-methylphenyl)]-propionyloxy]-1,1'-dimethylethyl]-2,4,8,10-tetraoxa-spiro[5.5]undecane, thiodiethylenebis[3-(3,5-di-t-butyl-4-hydroxyphenyl) propionate], N,N'-hexan-1,6-diylbis[3-(3,5-di-t-butyl-4-hydroxyphenyl)-propionamide] and the like. Examples of the sulfur antioxidant include dilauryl-3,3'-thiodipropionate, ditridecyl-3,3'-thiodipropionate, dimyristyl-3,3'-thiodipropionate, distearyl-3,3'-thiodipropionate, pentaerythrityltetrakis(3-laurylthiopropionate) and the like. Examples of the phosphorus antioxidant include tris[2-[[2,4,8,10-tetra-t-butylbenzo[d,f][1,3,2]dioxaphosphephin-6-yl]oxy]ethyl]amine, bis[2,4-bis(1,1-dimethylethyl)-6-methylphenyl]ethyl ester phosphite and tetrakis(2,4-di-t-butylphenyl)[1,1-biphenyl]-4,4'-diyl bisphonate. The antioxidants may be used solely or in combination of two or more of them.

The lubricant is not particularly limited, and products that are ordinarily used may be used. Among these, a metallic soap lubricant, a fatty acid ester lubricant, an aliphatic hydrocarbon lubricant and the like are preferred, and a metallic soap lubricant is particularly preferred. Examples of the metallic soap lubricant include barium stearate, calcium stearate, zinc stearate, magnesium stearate and aluminum stearate. These may be used as a composite.

The ultraviolet ray absorbent is not particularly limited, and products that are ordinarily used may be used. Among these, a benzophenone ultraviolet ray absorbent, a benzotriazole ultraviolet ray absorbent and a cyanoacrylate ultraviolet ray absorbent are preferred, and a benzophenone ultraviolet ray absorbent is particularly preferred. Examples of the benzophenone ultraviolet ray absorbent include 2-(2'-hydroxy-5'-methyphenyl)benzotriazole, 2-(2'-hydroxy-5'-butylphenyl)benzotriazole and 2-(2-hydroxy-3'-t-butylphenyl)benzotriazole.

The additives are not limited to the aforementioned specific examples, and any material may be added unless the objects and advantages of the invention are impaired.

### (Solvent)

In the invention, a solvent is preferably used for effectively releasing the layers of the synthetic smectite for dispersing in the vinyl ester resin composition. Examples of the solvent include an aromatic hydrocarbon compound such as benzene, toluene, xylene, ethylbenzene, mesitylene, n-propylbenzene and isopropylbenzene; an acetate ester compound such as methyl acetate, ethyl acetate, propyl acetate and butyl acetate; a ketone compound such as acetone, methyl ethyl ketone and methyl isobutyl ketone; an ether compound such as diethyl ether, tetrahydrofuran and 1,4-dioxane; an alcohol compound such as methanol, ethanol, (iso)propanol and butyl alcohol; a halogenated hydrocarbon compound such as chloroform and methylene chloride; a nitrogen-containing solvent such as N,N-dimethylformamide, N-methylpyrrolidone, pyridine and acetonitrile; and the like. Preferred examples thereof include water, an alcohol compound such as methanol, toluene, xylene and N-methylpyrrolidone.

The proportion of the solvent to the synthetic smectite varies largely depending on the kind of the solvent, and is from 100 to 10,000 parts by mass, and more preferably from 200 to 5,000 parts by mass, per 100 parts by mass of the synthetic smectite. In the case where the proportion of the solvent is less than 100 parts by mass, the viscosity of the mixture liquid is increased to make it difficult to mix uniformly.

### (Method for producing transparent sheet)

The transparent sheet of the invention can be produced by coating a mixture of synthetic smectite organized with a quaternary ammonium salt and/or a quaternary phosphonium salt and a vinyl ester resin composition on a substrate, curing the coated mixture with EB or UV or by heating, and releasing the resulting transparent sheet.

The mixture of the synthetic smectite, the vinyl ester resin composition and the solvent can be produced, for example, by (1) a method of mixing a solution containing the resin component dissolved in a solvent and a dispersion liquid containing the synthetic smectite dispersed in a solvent, (2) a method of adding and dissolving the resin component directly to a dispersion liquid containing the synthetic smectite dispersed in a solvent, (3) a method of adding and dispersing the synthetic smectite to the resin component having been dissolved in a solvent, or (4) a method of dissolving and dispersing a mixture obtained by heating and kneading the resin component and the synthetic smectite in a solvent. Among these, such a method is particularly preferred that a solution containing the resin component dissolved in a solvent and a dispersion liquid containing the synthetic smectite dispersed in a solvent are mixed, from the standpoint of dispersibility of the synthetic smectite. The dispersing method is not particularly limited, and a known method may be used, such as a heating treatment, Mixrotor, a magnetic stirrer, a homogenizer, a Henschel mixer, a beads mill, an ultra-high pressure atomizing device and application of ultrasonic wave.

The dispersion liquid of the synthetic smectite, the vinyl ester resin composition and the solvent is depressurized for deaeration and concentration, whereby the viscosity of the dispersion liquid is controlled to a viscosity that is optimum for coating. The viscosity of the dispersion liquid is not particularly limited, but it is preferred that the viscosity is suitable for the forming method. For example, in the case of a roll coating method and a doctor knife coating method, the viscosity is preferably in a range of from 0.01 to 1,000 Pa·s at 25°C. A viscosity of less than 0.01 Pa·s or exceeding 1,000 Pa·s is not preferred since the workability is deteriorated. In the case where the viscosity is too high at ordinary temperature, the workability can be improved by increasing the temperature of the dispersion liquid. In the case where the depressurizing time is short, gaseous matters in the dispersion liquid cannot be sufficiently removed and form bubbles upon coating, drying and curing steps, thereby failing to provide a smooth transparent sheet.

Upon coating, the dispersion liquid having been deaerated and controlled in viscosity by concentrating under reduced pressure is used as a coating composition, and is coated on a smooth substrate such as glass, metal and a plastic film by a method that is ordinarily employed industrially, such as a direct gravure method, a reverse gravure method, a microgravure method, a roll coating method such as a two-roll bead coating method and a bottom feed three-roll reverse coating method, a doctor knife coating method, a die coating method, a dip coating method, a bar coating method, a coating method combining these methods, and the like. Among these, a roll coating method and a doctor knife coating method are preferred since these methods apply a force functioning in parallel to the substrate (shearing force) for orienting the synthetic smectite in the plane direction. The term "orienting in the plane direction" means that most of the synthetic smectite is oriented in parallel to the surface of the substrate. In the case where the synthetic smectite layers are oriented in the plane direction, the coefficient of thermal expansion of the transparent sheet in the plane direction can be effectively decreased. Furthermore, the layers of the synthetic smectite are oriented in the plane direction, whereby the total light transmittance is high even if the content of the synthetic smectite is large.

In the case where a solvent that is capable of being evaporated is used for dispersing the synthetic smectite and for controlling the viscosity, the synthetic smectite can be further oriented in the plane direction. Specifically, the mixture of the synthetic smectite, the vinyl ester resin composition and the solvent is applied on the substrate, and then only the solvent is evaporated, whereby the coating composition is contracted only in the thickness direction, thereby further orienting the synthetic smectite in the plane direction in the resin. In the case where the reactive monomer is used, it is preferred that a reactive monomer that has relatively low volatility is used in combination with a solvent having high volatility, and the solvent is dried under suitable conditions (such as temperature, pressure and time). The method of orienting the synthetic smectite in the plane direction by evaporating the solvent can be employed in combination with the roll coating method and/or the doctor knife coating method mentioned above, but a coating method without application of shearing force may be employed solely.

The temperature, at which the solvent is evaporated, is preferably from 0 to 200°C. A temperature of less than 0°C is not preferred since the evaporation speed becomes significantly lowered. A temperature exceeding 200°C is not preferred since bubbling of the solvent due to rapid evaporation and boiling or gelation of the resin occurs, which results in possibilities of decrease in surface smoothness and increase in haze value. The temperature is more preferably from 10 to 100°C. The pressure, at which the solvent is evaporated, is preferably from 1 Pa to 1 MPa. A pressure of lower than 1 Pa is not preferred since bumping may occur, which results in possibilities of decrease in surface smoothness and increase in haze value. The pressure is more preferably from 10 to 200 Pa. The period of time for evaporating the solvent is preferably from 1 to 120 minutes. In the case where the period is less than 1 minute, the solvent cannot be sufficiently evaporated, thereby forming bubbles upon curing. A period of time exceeding 120 minutes is not preferred since the productivity is decreased. Upon evaporating the solvent, a gas may be used, such as air, nitrogen, argon and carbon dioxide. The gas may contain an evaporated component of the solvent. The flow rate of the gas upon evaporating the solvent is preferably from 0.01 to 200 m/s. A flow rate of less than 0.01 m/s is not preferred since the evaporated component of the solvent is accumulated. A flow rate exceeding 200 m/s is not preferred since the coating composition becomes heterogeneous. The flow rate is more preferably from 0.1 to 50 m/s.

The composition is finally sandwiched with smooth substrates such as glass, metal and a plastic film, cured with EB or UV or cured by heating, followed by releasing from the substrate, to obtain a transparent sheet. In the case where the composition is not sandwiched with the smooth substrates such as glass, metal and a plastic film, the composition is cured with EB or UV or cured by heating in an inert gas (such as nitrogen, argon and carbon dioxide) atmosphere, followed by releasing from the substrate, to obtain a transparent sheet. Examples of the method include a method, in which the vinyl ester resin composition before curing having the synthetic smectite dispersed therein and containing the solvent is coated on a plane having a smooth surface, for example, a biaxially stretched polyethylene terephthalate film, in the aforementioned method, then the solvent is evaporated, sandwiched with biaxially stretched polyethylene terephthalate films having a smooth surface, and cured with EB or UV or cured by heating. The curing method is preferably EB curing from the standpoint of curing rate and coloration.

In the case where the vinyl ester resin composition is cured with EB, a polymerization initiator is not necessary. In the case where the composition is completely cured by after-curing, however, a thermal polymerization initiator may be used in combination. The electron beam acceleration voltage upon EB irradiation is from 30 to 500 kV, and preferably from 50 to 300 kV. The electron beam irradiation dose is from 1 to 300 kGy, and preferably from 5 to 200 kGy. In the case where the electron beam acceleration voltage is less than 30 kV, shortage of the transmitted electron beam may occur when the composition has a large thickness, and in the case where it exceeds 500 kV, the operation is economically deteriorated. An electron beam irradiation dose exceeding 300 kGy is not preferred since the substrate may be damaged.

In the case where the vinyl ester resin composition is cured with UV, the curing temperature is from 0 to 150°C, and preferably from 10 to 130°C. The UV irradiation time is from 0.01 to 10 hours, preferably from 0.05 to 1 hour, and further preferably from 0.1 to 0.5 hour. The UV accumulated light amount is from 10 to 5,000 mJ/cm². An accumulated light amount is less than 10 mJ/cm² is not preferred since the composition may be insufficiently cured. An accumulated light amount exceeding 5,000 mJ/cm² may decrease the productivity.

In the case where the vinyl ester resin composition is cured by heating, the curing temperature is from 30 to 160°C, and preferably from 40 to 130°C. In consideration of suppressing contraction and distortion upon curing, a method of slowly curing by increasing the temperature is preferable, and the curing time is from 0.5 to 100 hours, and preferably from 3 to 50 hours.

In the case where the vinyl ester resin composition is insufficiently cured after curing with EB or UV or by heating, the composition can be completely cured by after-curing. Upon performing the after-curing, the transparent sheet may be released from the smooth substrate such as glass, metal and a plastic film, or may not be released therefrom. The temperature for the after-curing is from 50 to 300°C, and preferably from 80 to 250°C. The period of time for the after-curing is from 0.1 to 10 hours, and preferably from 0.5 to 5 hours. The pressure for the after-curing may be a depressurized or pressurized atmosphere of from 1.0 × 10⁻⁷ Pa to 1 MPa, and preferably from 1.0 × 10⁻⁶ Pa to 0.5 MPa. The atmosphere for the after-curing may be such atmospheres as air, nitrogen, argon and carbon dioxide, and a nitrogen atmosphere is preferred from the standpoint of decreasing coloration.

In the case where a transparent sheet containing two or more layers is produced, such methods may be employed as a method of coating (and drying) one layer on a substrate firstly and repeatedly coating (and drying) other layers thereon, followed by subjecting to curing with EB or UV or curing by heating, and the releasing from the substrate, and a method of producing two or more sheets, and then the two or more sheets are laminated. In the case where two or more sheets are laminated, the interfaces of two sheets may be subjected to such a treatment as a corona treatment and an anchor coating.

### EXAMPLES

The invention will be described with reference to Synthesis Examples, Example and Comparative Examples below, but the invention is not limited to the description.

### (Flexibility)

The flexibility was evaluated by winding a resulting film on a glass rod having a diameter of 2 mm. The case where the film was able to be wound was evaluated as "pass", and the case where it was not able to be wound was evaluated as "fail".

### (Measurement of Coefficient of Thermal Expansion and Tg)

The coefficient of thermal expansion was measured with TMA/SS6100, produced by SII NanoTechnology Inc., in a tensile mode. A test piece in a film form had a thickness of 100 µm × 3 mm × 12 mm (chuck distance: 10 mm) and was applied with a tension of 0.001 kgf, the temperature of which was increased to 250°C at a temperature increasing rate of 5°C per minute in an atmosphere containing 100 mL/min of nitrogen and then decreased to 50°C, and the elongation rate of the test piece was measured by again increasing the temperature from 50°C to 250°C at a temperature increasing rate of 5°C per minute. The average coefficient of thermal expansion in the plane direction within a range of from 50 to 250°C was calculated from the difference in elongation between 50°C and 250°C and the temperature difference (200°C). The temperature of the discontinuous point in elongation rate was designated as the glass transition temperature (Tg).

### (Total Light Transmittance)

The total light transmittance was measured with an automatic haze meter, TC-H3DPK, produced by Tokyo Denshoku Co., Ltd., according to JIS K7361-1.

### (Haze)

The haze value was measured with an automatic haze meter, TC-H3DPK, produced by Tokyo Denshoku Co., Ltd., according to JIS K7136.

### Synthesis Example 1: Oligomer (1)

276.3 parts (parts by mass, hereinafter the same) of a hydrogenated bisphenol A epoxy resin ST-4000D (a trade name, epoxy equivalent: 725), produced by Tohto Kasei Co., Ltd., 202.5 parts of toluene and 0.19 part of 4-methoxyphenol (MEHQ: hydroquinone monomethyl ether) as a polymerization inhibitor were charged in a four-neck flask equipped with a thermostat, a stirrer, a Dimroth condenser and an air introducing tube, and the temperature was increased to 80°C while dry air was blown (20 ml/min), followed by stirring until the mixture became homogeneous. After the mixture was homogeneous, 27.5 parts of acrylic acid, produced by Kuraray Co., Ltd., and 1.24 parts of benzyltriphenylphosphonium chloride (TPP-ZC, a trade name, produced by Hokko Chemical Industry Co., Ltd.) as a catalyst were added and reacted at a temperature controlled to 110°C for 7 hours. The reaction was terminated at an acid value of 7.8 mgKOH/g to obtain an oligomer (1) (toluene solution).

### Synthesis Example 2: Oligomer (2)

1,625 g of diallyl 1,4-cyclohexanedicarboxylate, 327 g of propylene glycol and 0.813 g of dibutyltin oxide were charged in a 2-L three-neck flask equipped with distillation apparatus, and heated under a nitrogen stream while distilling off alcohol formed at 180°C. At the time when the amount of the alcohol distilled off was about 350 g, the reaction system was gradually depressurized to 6.6 kPa (over about 4 hours) to accelerate the distillation speed of allyl alcohol. After the distillate was substantially not generated, the reaction system was depressurized to 0.5 kPa, and the reaction was further performed for 1 hour, followed by cooling the reaction product to room temperature. The reaction product thus obtained is referred to as an oligomer (2).

### Example 1

24 g of toluene was placed in a 100-mL sample bottle, to which 3 g of oleophilic synthetic smectite (Smectite STN, produced by Co-op Chemical Co., Ltd., number average particle diameter: 50 nm, aspect ratio: 50, inorganic content: 71%) having been subjected to a cation exchanging treatment with trioctylmethylammonium salt was added little by little under stirring with a stirrer. After closing the sample bottle with a lid, the mixture was stirred with Mixrotor at room temperature for one day to obtain a smectite dispersion liquid. A toluene solution of the oligomer (1) (7 g in terms of resin amount) was added to the smectite dispersion liquid, and 0.35 g of an UV curing agent (Irgacure 651, produced by Ciba Specialty Chemicals Co., Ltd.) was added, followed by sufficiently stirring, to obtain a composition (1). The composition (1) was attached to an evaporator and stirred at room temperature under 20 kPa for 10 minutes for controlling the viscosity and removing the gaseous components in the composition.

The composition (1) was applied on a PET film (thickness: 50 µm) with a bar coater to a dry thickness of 100 µm. The composition was dried with a hot air dryer at 80°C for 30 minutes to evaporate toluene as a solvent, and then covered from above with a PET film (thickness: 50 µm). The composition was cured with UV at an UV irradiation dose of 1,000 mJ/cm2, and the PET films on both sides were released to obtain a sample film (1). The film had a coefficient of thermal expansion of 13 ppm/°C, and no Tg was observed therein. The total light transmittance thereof was 92%, and the haze thereof was 0.8%.

### Comparative Example 1

The same operations as in Example 1 were performed except that the oligomer (1) was changed to a bisphenol A vinyl ester resin (SP-1529X, a trade name, produced by Showa Highpolymer Co., Ltd.). However, upon adding the vinyl ester resin, the synthetic smectite dispersion liquid was agglutinated. The dispersion liquid was applied and dried on PET, but was not able to be applied uniformly, failing to obtain a film sample.

### Comparative Example 2

A sample film (3) was obtained by performing the same operations as in Example 1 except that the oligomer (1) was changed to the oligomer (2) (resin amount: 7 g), and the UV irradiation dose was changed to 3,000 J/cm². The film had a coefficient of thermal expansion of 84 ppm/°C, and no Tg was observed therein. The total light transmittance thereof was 91%, and the haze thereof was 2.1%.

### Comparative Example 3

A sample film (4) was obtained by performing the same operations as in Example 1 except that the oleophilic synthetic smectite was changed to oleophilic natural smectite (natural smectite S-Ben NX, produced by Hojun Co., Ltd.) having been subjected to a cation exchanging treatment with dimethyldioctadecylammonium salt. The film had a coefficient thermal expansion of 141 ppm/°C, and no Tg was observed therein. The total light transmittance thereof was 88%, and the haze thereof was 21.3%.

**Table 1**

| | Resin | Smectite | | Flexibility (2 mm in diameter) | Coefficient of thermal expansion (ppm/°C) | Total light transmittance (%) | Haze (%) |
|---|---|---|---|---|---|---|---|
| | | Kind | Amount added (% by mass) | | | | |
| Example 1 | Oligomer (1) | synthesized product | 30 | Pass | 13 | 92 | 0.8 |
| Comparative Example 1 | SP-1529X | synthesized product | 30 | -- | -- | -- | -- |
| Comparative Example 2 | Oligomer (2) | synthesized product | 30 | Pass | 84 | 91 | 2.1 |
| Comparative Example 3 | Oligomer (1) | natural product | 30 | Fail | 141 | 88 | 21.3 |

| | | | | | | | |
|---|---|---|---|---|---|---|---|
| * --: incapable measurement | | | | | | | |

## Claims

1. A transparent composite material comprising a cured product of a resin composition having from 60 to 90% by mass of a vinyl ester resin composition which has a vinyl ester resin being synthesized from an aliphatic epoxy compound, having dispersed therein from 10 to 40% by mass of synthetic smectite that is organized with a quaternary ammonium salt and/or a quaternary phosphonium salt and has a number average particle diameter of from 10 to 300 nm and an aspect ratio of from 10 to 300, the composition being cured.

2. The transparent composite material according to claim 1, wherein the vinyl ester resin is synthesized from an epoxy compound having an alicyclic structure.

3. The transparent composite material according to claim 1 or 2, wherein the vinyl ester resin is synthesized from a hydrogenated bisphenol A epoxy resin.

4. The transparent composite material according to claim 1, wherein the vinyl ester resin composition comprises from 30 to 100% by mass of a vinyl ester resin and from 0 to 70% by mass of a reactive monomer having an ethylenic unsaturated group.

5. The transparent composite material according to claim 1, wherein the synthetic smectite is at least one selected from synthetic hectorite, synthetic saponite and synthetic stevensite.

6. The transparent composite material according to claim 1, wherein the quaternary ammonium salt for organizing the synthetic smectite is at least one selected from lauryltrimethylammonium salt, stearyltrimethylammonium salt, trioctylmethylammonium salt, distearyldimethylammonium salt, di-hydrogenated beef tallow dimethylammonium salt, distearyldibenzylammonium salt and N-polyoxyethylene-N-lauryl-N,N-dimethylammonium salt.

7. The transparent composite material according to claim 1, 5 or 6, wherein a hydroxyl group present on a surface of the synthetic smectite is treated with a surface modification agent.

8. The transparent composite material according to claim 7, wherein the surface modification agent is selected from a silane coupling agent, a titanate coupling agent, a glycidyl compound, an isocyanate compound, carboxylic acids and alcohols.

9. A transparent plate comprising the transparent composite material according to claim 1 and having an average coefficient of thermal expansion of 30 ppm/°C or less in a planar direction at from 50 to 250°C and a total light transmittance of 85% or more per 100 µm in thickness.

10. A method for producing the transparent composite material according to claim 1, comprising the steps of: coating a composition comprising a vinyl ester resin compound, synthetic smectite and a solvent, before curing, on a flat plane having a smooth surface; then drying the solvent; holding the flat plane with sheets or films having a smooth surface; and curing with an electron beam (EB), an ultraviolet ray (UV) or heat.

11. A display device comprising, as a substrate, the transparent composite material according to one of claims 1 to 8.

12. The display device according to claim 11, wherein the display device is a liquid crystal display, an organic EL display or electronic paper.

13. A substrate for a solar cell comprising, as a substrate, the transparent composite material according to one of claims 1 to 8.

## Patentansprüche

1. Transparentes Verbundmaterial, das ein gehärtetes Produkt einer Harzzusammensetzung mit 60 bis 90 Massen-% einer Vinylesterharzzusammensetzung umfasst, die ein Vinylesterharz enthält, das aus einer aliphatischen Epoxyverbindung synthetisiert worden ist, wobei darin 10 bis 40 Massen-% synthetisches Smectit dispergiert sind, das mit einem quartären Ammoniumsalz und/oder einem quartärem Phosphoniumsalz organisiert ist und ein Zahlenmittel des Teilchendurchmessers von 10 bis 300 nm und ein Längen-/Breitenverhältnis von 10 bis 300 aufweist, wobei die Zusammensetzung gehärtet ist.

2. Transparentes Verbundmaterial nach Anspruch 1, wobei das Vinylesterharz aus einer Epoxyverbindung mit einer alicyclischen Struktur synthetisiert ist.

3. Transparentes Verbundmaterial nach Anspruch 1 oder 2, wobei das Vinylesterharz aus einem hydrierten Bisphenol A Epoxyharz synthetisiert ist.

4. Transparentes Verbundmaterial nach Anspruch 1, wobei die Vinylesterharzzusammensetzung 30 bis 100 Massen-% eines Vinylesterharzes und 0 bis 70 Massen-% eines reaktiven Monomers mit einer ethylenisch ungesättigten Gruppe enthält.

5. Transparentes Verbundmaterial nach Anspruch 1, wobei das synthetische Smectit mindestens eines ist, das unter synthetischem Hectorit, synthetischem Saponit und synthetischem Stevensit ausgewählt ist.

6. Transparentes Verbundmaterial nach Anspruch 1, wobei das quartäre Ammoniumsalz zum Organisieren des synthetischen Smectits mindestens eines ist, das unter Lauryltrimethylammoniumsalz, Stearyltrimethylammoniumsalz, Trioctylmethylammoniumsalz, Diestearyldimethylammoniumsalz, dihydriertem Rindertalgdimethylammoniumsalz, Distearyldibenzylammoniumsalz und N-Polyoxyethylen-N-lauryl-N,N-dimethylammoniumsalz ausgewählt ist.

7. Transparentes Verbundmaterial nach Anspruch 1, 5 oder 6, wobei eine auf einer Oberfläche des synthetischen Smectits vorhandene Hydroxygruppe mit einem Oberflächenmodifizierungsmittel behandelt ist.

8. Transparentes Verbundmaterial nach Anspruch 7, wobei das Oberflächenmodifizierungsmittel unter einem Silankupplungsmittel, einem Titanatkupplungsmittel, einer Glycidylverbindung, einer Isocyanatverbindung, Carbonsäuren und Alkoholen ausgewählt ist.

9. Transparente Platte, welche das transparente Verbundmaterial nach Anspruch 1 aufweist und einen mittleren Koeffizienten der thermischen Expansion von 30 ppm/°C oder weniger in einer planaren Richtung bei 50 bis 250 °C und eine Gesamtlichtdurchlässigkeit von 85 % oder mehr pro 100 µm Dicke aufweist.

10. Verfahren zum Herstellen eines transparenten Verbundmaterials nach Anspruch 1, welches die folgenden Stufen umfasst: das Auftragen einer Zusammensetzung, die eine Vinylesterharzverbindung, synthetisches Smectit und ein Lösungsmittel enthält, vor dem Härten auf eine flache Ebene mit einer glatten Oberfläche; das anschließende Trocknen des Lösungsmittels; das Halten der flachen Ebene mit Flächen oder Filmen einer glatten Oberfläche; und Härten mit einem Elektronenstrahl (EB), einem ultravioletten Strahl (UV) oder Hitze.

11. Anzeigevorrichtung, die als ein Substrat das transparente Verbundmaterial nach einem der Ansprüche 1 bis 8 enthält.

12. Anzeigevorrichtung nach Anspruch 11, wobei die Anzeigevorrichtung eine Flüssigkristallanzeige, eine organische EL-Anzeige oder ein elektronisches Papier ist.

13. Substrat für eine Solarzelle, welches als ein Substrat das transparente Verbundmaterial nach einem der Ansprüche 1 bis 8 enthält.

## Revendications

1. Matériau composite transparent comprenant un produit durci d'une composition de résine présentant de 60 à 90 % en masse d'une composition de résine d'ester vinylique qui présente une résine d'ester vinylique synthétisée à partir d'un composé époxy aliphatique, présentant dispersés dans celle-ci de 10 à 40 % en masse de smectite synthétique qui est organisée avec un sel d'ammonium quaternaire et/ou un sel de phosphonium quaternaire et qui présente un diamètre moyen de particule en nombre de 10 à 300 nm et un rapport d'allongement de 10 à 300, la composition étant durcie.

2. Matériau composite transparent selon la revendication 1, dans lequel la résine d'ester vinylique est synthétisée à partir d'un composé époxy présentant une structure alicyclique.

3. Matériau composite transparent selon la revendication 1 ou 2, dans lequel la résine d'ester vinylique est synthétisée à partir d'une résine époxy de bisphénol A hydrogénée.

4. Matériau composite transparent selon la revendication 1, dans lequel la composition de résine d'ester vinylique comprend de 30 à 100 % en masse d'une résine d'ester vinylique et de 0 à 70 % en masse d'un monomère réactif présentant un groupe éthylénique insaturé.

5. Matériau composite transparent selon la revendication 1, dans lequel la smectite synthétique est au moins une choisie parmi l'hectorite synthétique, la saponite synthétique et la stévensite synthétique.

6. Matériau composite transparent selon la revendication 1, dans lequel le sel d'ammonium quaternaire pour organiser la smectite synthétique est au moins un choisi parmi un sel de lauryltriméthylammonium, un sel de stéaryltriméthylammonium, un sel de trioctylméthylammonium, un sel de distéaryldiméthylammonium, un sel de di-(suif de boeuf hydrogéné)diméthylammonium, un sel de distéaryldibenzylammonium et un sel de N-polyoxyéthylène-N-lauryl-N,N-diméthylammonium.

7. Matériau composite transparent selon la revendication 1, 5 ou 6, dans lequel un groupe hydroxyle présent sur une surface de la smectite synthétique est traité avec un agent de modification de surface.

8. Matériau composite transparent selon la revendication 7, dans lequel l'agent de modification de surface est choisi parmi un agent de couplage de silane, un agent de couplage de titanate, un composé de glycidyle, un composé d'isocyanate, des acides carboxyliques et des alcools.

9. Plaque transparente comprenant le matériau composite transparent selon la revendication 1 et présentant un coefficient moyen de dilatation thermique de 30 ppm/°C ou inférieur dans une direction plane à de 50 à 250°C et un coefficient de transmission totale de lumière de 85 % ou supérieur pour 100 µm d'épaisseur.

10. Procédé de production du matériau composite transparent selon la revendication 1 comprenant les étapes consistant :
à déposer une composition comprenant un composé de résine d'ester vinylique, une smectite synthétique et un solvant, avant le durcissement, sur un plan aplati présentant une surface lisse ; à sécher ensuite le solvant, à maintenir le plan aplati avec des feuilles ou des films présentant une surface lisse ; et à faire durcir avec un faisceau d'électrons (EB), un rayonnement ultraviolet (UV) ou de la chaleur.

11. Dispositif d'affichage comprenant, comme substrat, le matériau composite transparent selon l'une quelconque des revendications 1 à 8.

12. Dispositif d'affichage selon la revendication 11, dans lequel le dispositif d'affichage est un dispositif à cristaux liquides, un affichage EL organique ou un papier électronique.

13. Substrat destiné à une cellule photovoltaïque comprenant, comme substrat, le matériau composite transparent selon l'une quelconque des revendications 1 à 8.
